Europäisches Patentamt

(19) European Patent Office

Office européen des brevets

(11) Veröffentlichungsnummer : **0 023 231**
**B1**

(12) **EUROPÄISCHE PATENTSCHRIFT**

(45) Veröffentlichungstag der Patentschrift :
**11.08.82**

(51) Int. Cl.³ : **H 01 L 21/312, H 01 L 21/47**

(21) Anmeldenummer : **79102675.0**

(22) Anmeldetag : **27.07.79**

(54) **Optisches Lithographieverfahren und Einrichtung zum Kopieren eines Musters auf eine Halbleiterscheibe.**

(43) Veröffentlichungstag der Anmeldung :
**04.02.81 (Patentblatt 81/05)**

(45) Bekanntmachung des Hinweises auf die Patenterteilung : **11.08.82 Patentblatt 82/32**

(84) Benannte Vertragsstaaten :
**AT BE CH DE FR GB IT LU NL SE**

(56) Entgegenhaltungen :
**DE B 1 944 448**
**US A 3 346 475**

**WILHELM H. WESTPHAL « PHYSIK » 22. bis 24.
Auflage 1963, SPRINGER-VERLAG, Berlin-GÖT-
TINGEN-Heidelberg, Seite 527 bis 529**

**ELEKTRONIKER, 18. Jahrgang, Heft 2 Februar
1979 Fachschriftenverlag Aarau Dr. H. SCHAUM-
BURG « Lithographietechniken für höchstintegrierte Schaltungen » Seiten 41 bis 43**

**« Lexikon Technik und exakte Naturwissenschaften » Band 5 : « Gesteine-Kalisalpeter » Oktober
1972, FISCHER TASCHENBUCHVERLAG,
Frankfurt am Main, Seite 1 510**

(73) Patentinhaber : **Tabarelli, Werner W., Dr.
Schloss-Strasse 5
FL-9490 Vaduz (LI)**

(72) Erfinder : **Tabarelli, Werner W., Dr.
Schloss-Strasse 5
FL-9490 Vaduz (LI)**
Erfinder : **Löbach, Ernst, Dr.
Tonagass 374
FL-9492 Eschen (LI)**

(74) Vertreter : **Hofinger, Engelbert, Dr.
Wilhelm-Greil-Strasse 16
A-6020 Innsbruck (AT)**

# Optisches Lithographieverfahren und Einrichtung zum Kopieren eines Musters auf eine Halbleiterscheibe

Durch moderne Dotiertechniken und hochentwickelte Verfahren zur Abscheidung von Schichten auf Halbleiteroberflächen ist heute die Strukturierung in vertikaler Richtung bei der Fertigung integrierter Schaltungen bereits in einem Ausmaß möglich, hinter dem die Möglichkeiten zur Strukturierung in horizontaler Richtung weit zurückbleiben. Einer Verfeinerung der Strukturierung integrierter Schaltungen in der Lateraldimension der Halbleiterscheibe gelten daher derzeit intesive Bemühungen. In diesem Sinne findet einerseits ein Übergang von der Ganzscheibenbelichtung zur schrittweisen Belichtung mit einer Vielzahl identischer Schaltungen versehener Halbleiterscheiben statt. Parallel dazu verläuft die Suche nach Alternativen zur optischen Lithographie auf der heute alle praktisch angewandten Verfahren zur Herstellung integrierter Schaltungen beruhen. Insbesondere handelt es sich hiebei um die Elektronenstrahllithographie und die Röntgenstrahllithographie. Die Elektronenstrahllithographie ist zwar zur Maskenherstellung heute schon praktisch anwendbar, die direkte Bearbeitung der Halbleiterscheibe mit Elektronenstrahlen ist jedoch nicht nur sehr kompliziert, sondern schon durch den geringen Durchsatz viel zu teuer, ganz abgesehen davon, daß bei der Einführung eines solchen grundsätzlich neuen Verfahrens eine Reihe in der Photolithographie gesammelter Erfahrungen, beispielsweise betreffend die Verwendung bestimmter Photolacke, nicht anwendbar sind. Die Röntgenstrahllithographie befindet sich in einem noch früheren Experimentalstadium und ihrer Entwicklung steht nicht nur das Fehlen hinreichend starker Röntgenquellen, sondern auch der geringe Wirkungsgrad dieser Quellen und eine komplizierte Maskentechnik entgegen.

Praktische Fortschritte sind in der skizzierten Situation am raschesten durch eine Verbesserung in der optischen Lithographie, bei der durch lokale Belichtung einer Photolackschicht lokale Änderungen in der molekularen Struktur des Lacks erzielt werden, zu erwarten. In diesem Sinne strebt man durch Verwendung von sogenanntem « tiefen » UV-Licht (etwa 270 nm) ein höheres Auflösungsvermögen an, verschiebt also die durch Beugungseffekte gezogene Grenze. Das Arbeiten in diesem Wellenlängenbereich hat vor allem den Nachteil, daß die herkömmlichen optischen Komponenten, also Objektive, Filter, aber auch Photolacke erst mühsam entwickelt werden müssen. Ein weiterer Nachteil entsteht daraus, daß die Justierarbeiten, die ein Kernproblem aller industriellen Lithographieverfahren darstellen, am besten mit sichtbarem Licht durchgeführt werden. Bei Verwendung von UV-Licht als Belichtungslicht müssen also die Einstellarbeiten entweder mit im Spektrum entfernt liegendem sichtbarem Licht und mit den daraus resultierenden Ungenauigkeiten ausgeführt werden, oder es muß das mühsame und schwierige Arbeiten mit UV-Detektoren in Kauf genommen werden.

Grundsätzlich ist es möglich, das Auflösungsvermögen eines Objektivs dadurch zu verbessern, daß der Öffnungswinkel vergrößert wird. Hiebei sind jedoch nicht nur von der Konstruktion der Projektionsobjektive her Grenzen gesetzt, sondern vor allem durch ein typisches Problem der Lithographie struktuerierter Oberflächen, nämlich der Vignettierung, also der Abschattung von Teilen der abbildenden Strahlen durch vorstehende Teile der Halbleiteroberfläche. Der Öffnungswinkel liegt bei Einrichtungen zur Photolithographie aufgrund dieses Effekts notwendigerweise unter jenem Betrag, bei dem an der Grenzfläche des ebenen Substrates Totalreflexion auftreten würde, weshalb Maßnahmen zur Ausschaltung der Totalreflexion zum Zweck der Vergrößerung des Öffnungswinkels nicht in Betracht gezogen wurden. Der Erfindung liegt die Überlegung zugrunde, daß eine ansonsten unter dem Gesichtspunkt der Ausschaltung der Totalreflexion betrachtete Maßnahme, nämlich die Verwendung einer Immersionsflüssigkeit, in der Photolithographie trotz des hier notwendigerweise beschränkten Öffnungswinkels mit Erfolg angewendet werden kann. Dies ist deshalb der Fall, weil das Auflösungsvermögen des Projektionsobjektivs mit der numerischen Apertur (NA) steigt, welche durch die Beziehung $NA = n \sin \delta$ (n Brechungsindex, $\delta$ halber Öffnungswinkel) gegeben ist. Die Einführung einer Immersionsflüssigkeit steigert somit das Auflösungsvermögen durch Steigerung des Brechungsindex.

Wenn also erfindungsgemäß vorgesehen ist, daß wenigstens während des Belichtungsvorganges der Zwischenraum zwischen der Scheibe und der dieser zugewandten Grenzfläche des Projektionsobjektivs mit einer lichtdurchlässigen Flüssigkeit gefüllt gehalten wird, so wird hiedurch der für die Lithographie strukturierter Oberflächen spezifische Vorteil erzielt, daß das Auflösungsvermögen trotz kleinerer Einfallwinkel aufrechterhalten und die Gefahr einer Vignettierung bei gleicher NA verringert werden kann. In gewissem Sinn wird durch die Verwendung einer Immersionsflüssigkeit der gleiche Effekt erzielt, wie er durch den Übergang zur Verwendung von UV-Licht angestrebt wird : durch die Verwendung von UV-Licht angestrebt wird : durch die Verwendung kürzerer Wellenlängen wird die durch Beugungseffekte gezogene Grenze des Auflösungsvermögens hinausgeschoben, dies jedoch ohne den Bereich des sichtbaren Lichtes verlassen oder sich weit davon entfernen zu müssen, da im Falle der Erfindung die Änderung der Wellenlänge ja nicht durch eine Frequenzänderung, sondern durch Änderung des Brechungsindex zustande kommt.

Die Tragweite der Erfindung im Rahmen der Herstellung von integrierten Schaltungen geht dadurch wesentlich über das bisher angeführte hinaus, als ohne weiteres die Möglichkeit besteht, bei der Wahl der erfindungsgemäß vorgesehenen Immersionsflüssigkeiten auf die Eigenschaften, insbesondere den Brechungsindex, des verwendeten Photolacks Rücksicht zu nehmen.

Eines der ganz großen Probleme bei der Belichtung von Photolackschichten auf Halbleiterscheiben, insbesondere bei der Erzeugung feiner Strukturen, ist die homogene Belichtung des gesamten Bildfeldes. Eine Ungleichmäßigkeit von ca. 1 % gilt dabei als guter Richtwert. Die gleichmäßige Ausleuchtung des Bildfeldes ist zwar eine notwendige, aber längst noch keine ausreichende Bedingung für das erstrebte Ziel. Dieses wäre nur dann der Fall, wenn die Halbleiterscheibenoberfläche mit der auf ihr befindlichen Lackschicht selbst homogen wäre. Dies ist aber spätestens nach dem ersten Lithographie-Schritt nicht mehr der Fall, da ja nun die ersten gewünschten Strukturen erzeugt worden sind. Im allgemeinen befinden sich während der verschiedenen Herstellungsschritte einer integrierten Schaltung auf der Halbleiteroberfläche zahlreiche Stufen, Gräfen, Erhöhungen, Böschungen etc. Dabei bezieht sich die Inhomogenität der Oberfläche nicht nur auf die Topographie, sondern auch auf die unterschiedliche Zusammensetzung und Kristallstruktur einzelner Bereiche auf der Oberfläche. In diesem Zusammenhang interessiert lediglich das mit dem unterschiedlichen Aufbau zusammenhängende variierende Reflexionsvermögen dieser Bereiche.

Wird nun auf eine solche Oberfläche eine Photolackschicht aufgebracht, so ergeben sich unweigerlich Schwankungen der Lackdicke. Nach dem Trockungsprozess folgt das Profil der Lackoberfläche nur bedingt dem Profil der Grenzfläche Lack-Substrat.

Fällt Licht auf eine solche Lackschicht, so treten nacheinander folgende physikalische Erscheinungen auf:

Das auftreffende Licht wird an der Grenzfläche Luft-Lack zum Teil reflektiert, zum Teil gebrochen. Der gebrochene Anteil dringt in die Lackschicht ein und trägt zur Belichtung bei (sofern es sich um Licht der Belichtungswellenlänge handelt). Bei streifender Inzidenz, z.B. an steilen Böschungen der Lackoberfläche, steigt der reflektierte Anteil stark an.

Das eindringende Licht klingt entsprechend dem Schwächungskoeffizienten des Lacks ab, trifft mehr oder weniger geschwächt auf die Grenzfläche Lack-Substrat und wird von dieser teils absorbiert, teils reflektiert.

Dieser reflektierte Anteil bewegt sich seinerseits unter Schwächung wieder auf die Grenzfläche Lack-Luft zu, wird an dieser wiederum teils reflektiert, teils gebrochen transmittiert. An einzelnen Stellen kommt es sogar zur Totalreflexion.

Die innerhalb der Lackschicht hin und her laufenden Lichtwellen interferieren und bilden stehende Wellen aus. Diese stehenden Wellen tragen wesentlich zur Belichtung des Lacks bei. Die Intensität der stehenden Wellen ist in hohem Maße abhängig von der lokalen Lackdicke. Die Ausbildung stehender Wellen wird abgeschwächt, wenn innerhalb des Lackes bzw. an der Grenzfläche Lack-Substrat eine nennenswerte Absorption auftritt. Diese Situation ist aber im allgemeinen nicht gegeben.

Die hohe Reflexion bei streifender Inzidenz an Böschungen und die unterschiedliche Intensität stehender Wellen durch schwankende Lackdicke sind hauptsächlich dafür verantwortlich, daß trotz gleichmäßiger Beleuchtung eine inhomogene Belichtung von Lackschichten auf strukturierten Halbleiterscheiben stattfindet. Diese unhomogene Belichtung ist die Ursach für eine Variation der Linienbreiten von aus der Lackschicht zu erzeugenden linienhaften Strukturen. Je stärker die oben genannten Effekte auftreten, um so größer sind die Anforderungen an den Bildkontrast, d.h. die sogenannten MTF-Werte (von modulation transfer function) müssen dann für eine scharfe Abbildung groß sein. Umgekehrt können beim Fehlen der Störeffekte auch kleinere MTF-Werte verarbeitet werden, d.h., daß bei einer gegebenen numerischen Apertur feinere Linien abgebildet werden können.

Nach dem Stand der Technik gelingt es nur sehr unvollkommen, die erwähnten Störeffekte auszuschalten, indem man versucht, Lackdickenschwankungen gering zu halten und im übrigen Photolacke mit hoher Eigenabsorption zu verwenden, die aber wiederum den Nachteil hoher Belichtungszeiten aufweisen.

Wird hingegen nach der bevorzugten Ausführungsform der Erfindung die mit einer Lackschicht überzogene Scheibe in eine Immersionsflüssigkeit getaucht, deren Brechungsindex mit dem des Lackes übereinstimmt, so verschwindet die Grenzfläche Lack-Luft bzw. Lack-Immersionsflüssigkeit vom Standpunkt der Optik aus vollständig. Mithin entfallen die oben diskutierten Störeffekte vollständig. Als Folge können nun bei gleicher NA feinere Linien abgebildet werden.

Die Immersionsflüssigkeit soll also vorzugsweise einen Brechungsindex aufweisen, der nahe bei dem des Photolackes (n = ca. 1,6) liegt, ihr Absorptionskoeffizient auf den Arbeitswellenlängen soll vernachlässigbar sein. Natürlich muß sie so beschaffen sein, daß sie den Photolack nicht angreift, d.h. diesen nicht auflöst oder sonst irgendwie chemisch nachteilig reagiert, auch nicht unter dem Einfluß der Lichtstrahlung. Sie darf sich auch selbst nicht unter Strahlungseinfluß zersetzen und sollte sich gegen die verwendeten Baumaterialien inert verhalten. Um auch kleinste Zwischenräume auf der Lackoberfläche ausfüllen zu können, soll die Immersionsflüssigkeit gegenüber dem Lack benetzend wirken. Lose Partikel werden dabei unterspült und können dadurch nicht zu einem Vergrößerungseffekt führen. Trotz guter Benetzung muß die Immersionsflüssigkeit aber leicht von der Lackschicht ablösbar sein, damit eine problemlose Weiterbearbeitung möglich ist. Eine beschränkte Aufnahmefähigkeit von Wasser ist vorteilhaft, da kleine Wassertröpfchen, die nicht ganz vermeidbar sind, dadurch aufgelöst und optisch unwirksam gemacht werden. Geringe Viskosität erleichtert das Entweichen von Gasblasen, die sich optisch wie Staubpartikel auswirken und ermöglicht ein rasches Filtrieren der Immersionsflüssigkeit.

Die dauernde Kontrolle des Zustandes der Immersionsflüssigkeit gelingt am einfachsten unter Verwendung einer Einrichtung, bei der die Ansaugplatte, welche die Halbleiterscheibe während des Belichtungsvorganges festhält den Boden eines Behälters bildet, durch welche die Immersionsflüssigkeit langsam zirkuliert. Auf diese Weise kann nicht nur der Flüssigkeitsvorrat konstant gehalten werden, sondern es ist auch möglich, Verunreinigungen laufend durch Filterung zu entfernen und die Immersionsflüssigkeit zur Konstanthaltung der Temperatur der Halbleiterscheibe heranzuziehen. Die Lösung der letztgenannten Aufgabe ist deshalb so wichtig, weil es natürlich wenig bringt, die Genauigkeit der optischen Abbildung in den Submikronbereich vorzutreiben, wenn nicht gleichzeitig verhindert wird, daß sich die Halbleiterscheibe unter dem Einfluß von Wärmeschwankungen relativ zu den auftreffenden Strahlen bewegt.

Anschließend wird die Erfindung anhand der Zeichnungen näher erläutert :

Figur 1a und b illustriert dabei anhand von Ausschnitten durch die vertikal geschnittene Oberfläche der Halbleiterscheibe die Limitierung des Öffnungswinkels,

Figur 2 zeigt an einem Querschnitt durch den Halbleiter das Problem des Lackdickenschwankungen,

Figur 3 zeigt das Prinzip der Erfindung an einem schematischen Querschnitt durch Projektionsobjektiv und Halbleiterscheibe,

Figur 4 gibt anhand einer Seitenansicht der gesamten Belichtungseinrichtung eine Vorstellung von der tatsächlichen Anordnung der erfindungsgemäßen Einrichtung.

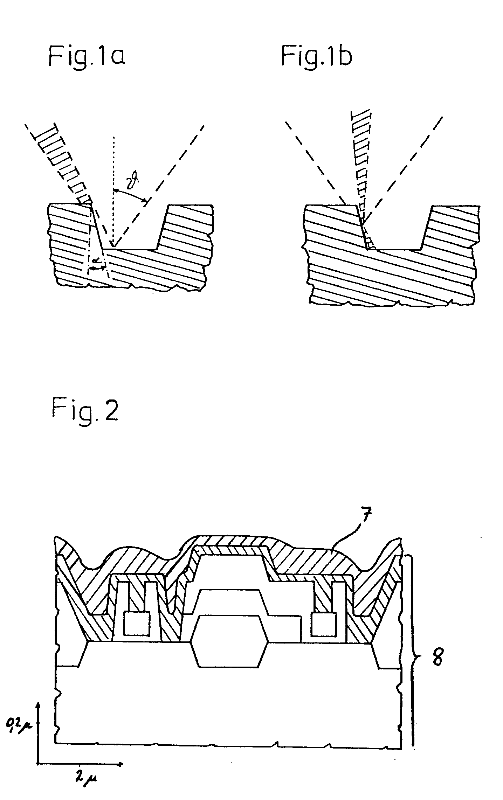

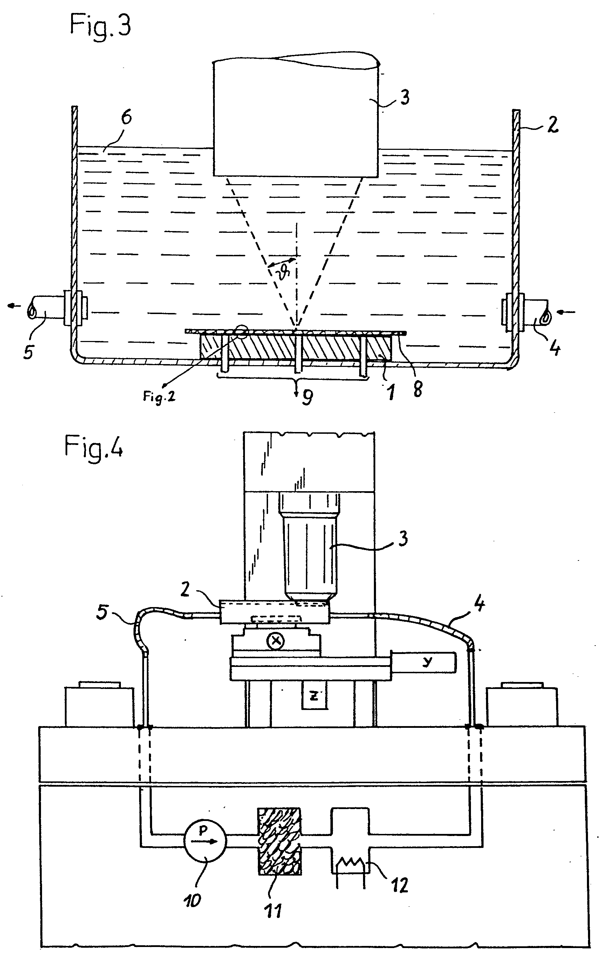

Wie in Fig. 1a dargestellt, wird ein einfallendes Strahlenbüschel daran gehindert, in einer Vertiefung der Oberfläche beispielsweise einer Halbleiterscheibe liegende Punkte zu erreichen, wenn die zur Vertiefung führende Böschung steiler ist als der Lichteinfall, wenn also gilt $\alpha < \delta$. Wie aus Fig. 1b hervorgeht, treten jedoch störende Effekte auch bereits dann auf, wenn die einfallenden Strahlen die zur Vertiefung führende Böschung zwar noch treffen, jedoch nahezu parallel zu dieser einfallen. Eine derartige streifende Inzidenz führt zu Unterbelichtung des Böschungsbereiches und entsprechender Überbelichtung des Grundes der Vertiefung durch reflektierte Strahlen. Im Zusammenhang mit Fig. 2, welche den Querschnitt durch die Oberflächenstruktur einer bereits mehreren Belichtungsschritten unterworfenen Halbleiterscheibe, wenn auch in zehnfacher Überhöhung, zeigt, wird klar, daß die Begrenzung des Öffnungswinkels zur Vermeidung von Vignettierungseffekten ein wesentliches Anliegen der Halbleiterlithographie ist.

Wie ebenfalls aus Fig. 2 hervorgeht, weist die photoempfindliche Lackschicht 7 auf der Scheibe 8 erhebliche Dickenunterschiede auf. Diese rühren daher, daß nach dem Auftragen der flüssige Lack zunächst ungeachtet der darunterliegenden Struktur eine ebene Lackoberfläche bildet, die nach dem Trocknen infolge des Entweichens des Lösungsmittels zwar in etwa, jedoch nicht genau, dem Profil der Substratoberfläche folgt. Vertiefungen der Oberfläche sind mit einer wesentlich höheren Lackschicht bedeckt, als Vorsprünge der Oberfläche.

Die dargestellten Schwankungen in der Lackdicke führen dadurch zu erheblichen Konsequenzen, als es von der Lackdicke abhängt, ob sich die in der Lackschicht entstehenden stehenden Wellen durch Interferenz verstärken oder schwächen. Betreffend die dieser Erscheinung zugrunde liegende Theorie wird beispielsweise auf die Arbeiten

J.D. Cuthbert, Solid State Technology, August 1977, Seite 59

Dietrich W. Widmann, Applied Optics, April 1975, Vol 14, No. 4, Seite 932

Dietrich W. Widmann and Hans Binder, IEEE Transactions on Electron Devices, Vol. ED-22, No. 7, July 1975, Seite 467-469

verwiesen. Im ungünstigsten Fall kann durch Unterschiede in der Lackdicke trotz homogener Belichtung ein örtlicher Unterschied in der Belichtungsintensität entstehen, welcher für die wenig belichteten Bereiche eine Verlängerung der Belichtungszeit um den Faktor 2,5 bedingt. Gravierender als die dadurch generell notwendig werdende Verlängerung der Belichtungszeit ist die Tatsache, daß die durch die Dickenunterschiede der Lackschicht bedingte verschiedene Lichtempfindlichkeit der einzelnen Oberflächenbereiche höhere Anforderungen an den Bildkontrast bedingt, d.h. die Möglichkeit der Abbildung feinerer Linien herabsetzt.

Wie bereits ausgeführt worden ist, lassen sich die angeführten Nachteile vermeiden, wenn die zu belichtende Halbleiterscheibe 8 bei der Belichtung ebenso wie das Projektionsobjektiv 3 in eine Flüssigkeit 6 eingetaucht wird, wie in Fig. 3 schematisch dargestellt ist. Einige Flüssigkeiten, die im Rahmen der Erfindung verwendbar sind, werden anschließend zusammen mit ihrem Brechungsindex, der in etwa jenem von Photolack ($n = 1,6$) entspricht, angeführt.

| | |
|---|---|
| Benzol | $n = 1,50$ |
| Monobrombenzol | $n = 1,56$ |
| 1-Brom-2-Jodbenzol | $n = 1,66$ |
| Dimethylnaphthalin | $n = 1,61$ |
| Äthylnaphtalin | $n = 1,60$ |
| | |
| 2,3-Dimethylanilin | $n = 1,57$ |
| 2-Phenyläthylamin | $n = 1,53$ |
| Isopropyloxybenzol | $n = 1,50$ |
| Monobromnaphthalin | $n = 1,66$ |

Alle diese Flüssigkeiten wirken gegenüber dem Photolack benetzend. Sie liegen dicht an der Oberfläche des Lacks an, wobei Verunreinigungen unterspült und damit optisch unwirksam gemacht werden. Die zweitgenannte Gruppe von Flüssigkeiten hat zudem den Vorzug daß sie kleinste Wassertröpfchen aufzulösen vermögen, sodaß diese nicht als kleine Kugellinsen wirken können.

Wie bereits ausgeführt worden ist, erhöht sich durch die Verwendung der Immersionsflüssigkeit 6 automatisch die numerische Apertur der Anordnung entsprechend dem Brechungsindex der Flüssigkeit, wodurch das Auflösungsvermögen steigt. Außerdem ergibt sich die Möglichkeit, bei der Konstruktion des Objektivs mit dem Öffnungswinkel bis an die durch das Auftreten von Vignettierung gegebene Grenze zu gehen, da bei einem bestimmten Öffnungswinkel der Bildfehler eines Immersionsobjektivs geringer ist als der des trockenen Systems. Gleichzeitig erlaubt der Wegfall der beim trockenen System an der Lackoberfläche entstehenden Effekte eine Abbildung bei wesentlich herabgesetztem Bildkontrast und damit eine weitere Herabsetzung der übertragbaren Linienbreite. Ein weiterer Effekt, der mit der optischen Einrichtung und dem durch diese abgebildeten Muster nichts zu tun hat, in seiner Bedeutung jedoch keineswegs unterschätzt werden soll, wird anschließend diskutiert :

Obwohl die Vorbereitung der Halbleiterscheiben für die Belichtung unter Bedingungen erfolgt, die denen für einen chirurgischen Eingriff entsprechen, ist es fast unmöglich, die Scheiben völlig staubfrei unter die Belichtungseinrichtung zu bringen. Bei der Feinheit der erzeugten Strukturen kann sich aber bereits ein normales Staubkorn dahin auswirken, daß der erzeugte Schaltkreis unbrauchbar ist. Die Ausschußrate bei den heute angewendeten Verfahren ist daher hoch, obwohl versucht wird z.B. durch Abblasen der Halbleiterscheibe kurz vor der Belichtung restliche Staubteilchen zu entfernen. Ein weiteres Problem in der Schwierigkeit, die Temperatur im Belichtungsbereich möglichst konstant zu halten, wobei Schwankungen über 1 °C bereits ausgesprochen schädlich sind.

Sowohl die Reinigung wie die Temperaturstabilisierung der Halbleiterscheibe ergeben sich bei der in Fig. 3 und 4 dargestellten Einrichtung als natürliche Folge des erfinderischen Grundgedankens. Die auf dem Träger 1 durch Vakuumleitungen 9 festgehaltene Halbleiterscheibe 8 wird von der Flüssigkeit 6 sowohl rein gehalten wie temperiert, wobei durch in den Behälter 2 führende Zuleitungen 4 und Ableitungen 5 stets konstante Verhältnisse hergestellt werden. Diese Zu- bzw. Ableitungen, die flexibel gestaltet sind und die zur schrittweisen Belichtung notwendige Verschiebung in den Richtungen X und Y und die Justierung in Z-Richtung erlauben, gehören zu einem Kreislauf, der außer einem nicht dargestellten Vorratsbehälter eine Pumpe 10, ein Filter 11 und eine in Abhängigkeit von der festgestellten Temperatur heizende oder kühlende Temperiereinrichtung 12 umfaßt.

## Ansprüche

1. Optisches Lithographieverfahren zum Kopieren eines Musters auf eine Halbleiterscheibe, insbesondere zur Herstellung von integrierten Schaltungen, wobei eine Maske durch ein zwischengeschaltetes Projektionsobjektiv auf eine photoempfindliche Schicht der Halbleiterscheibe abgebildet wird, dadurch gekennzeichnet, daß wenigstens während des Belichtungsvorganges der Zwischenraum zwischen der Halbleiterscheibe und der dieser zugewandten Grenzfläche des Projektionsobjektivs mit einer lichtdurchlässigen Flüssigkeit gefüllt gehalten wird.

2. Verfahren nach Anspruch 1, dadurch gekennzeichnet, daß der Brechungsindex der Flüssigkeit ähnlich dem der photoempfindlichen Schicht der Halbleiterscheibe, vorzugsweise nicht mehr als 10 % von dem dieser Schicht abweichend, gewählt wird.

3. Verfahren nach Anspruch 1 oder 2, dadurch gekennzeichnet, daß die Flüssigkeit zwischen der Halbleiterscheibe und dem Projektionsobjektiv ständig ausgetauscht und dabei temperiert und/ oder gefiltert wird.

4. Verfahren nach einem der Ansprüche 1 bis 3, dadurch gekennzeichnet, daß eine Flüssigkeit verwendet wird, welche einen die photoempfindliche Schicht bildenden Lack benetzt und geringe Viskosität aufweist.

5. Verfahren nach Anspruch 4, dadurch gekennzeichnet, daß Benzol, Monobrombenzol, 1-Brom-2-Jodbenzol, Dimethylnaphthalin oder Äthylnaphthalin verwendet wird.

6. Verfahren nach Anspruch 4, dadurch gekennzeichnet, daß eine Wasser aufnehmende Flüssigkeit, verwendet wird.

7. Verfahren nach Anspruch 6, dadurch gekennzeichnet, daß 2,3-Dimethylanilin, 2-Phenyläthylamin, Isopropyloxybenzol oder Monobromnaphthalin verwendet wird.

8. Einrichtung zur Durchführung des Verfahrens nach einem der Ansprüche 1 bis 7, bei welcher eine Halbleiterscheibe unterhalb eines Projektionsobjektivs auf einem Träger angeordnet ist, dadurch gekennzeichnet, daß der Träger (1) in einem oben offenen Behälter (2) angeordnet ist, dessen oberer Rand höher liegt als die untere Begrenzungsfläche des Projektionsobjektivs (3).

9. Einrichtung nach Anspruch 8, dadurch gekennzeichnet, daß der Behälter (2) mit Zu- und Ableitungen (4, 5) für eine Flüssigkeit (6) versehen ist.

10. Einrichtung nach Anspruch 9, dadurch gekennzeichnet, daß im Flüssigkeitskreislauf mindestens ein Filter vorgesehen ist.

11. Einrichtung nach Anspruch 9 oder 10, dadurch gekennzeichnet, daß im Flüssigkeitskreislauf eine Einrichtung zur Erwärmung bzw. Abkühlung der Flüssigkeit vorgesehen ist.

## Claims

1. A photolithographic method of copying a pattern onto a semiconductor disk, particularly for the manufacture of integrated circuits, whereby a mask is imaged onto a photosensitive layer of the semiconductor disk by means of an interposed projection lens, characterized in that at least during exposure the space between the semiconductor disk and the boundary face of the projection lens facing the disk remains filled with a transparent liquid.

2. A method according to claim 1, characterized in that the refractive indic of the liquid is selected to be similar to the refractive index of the photosensitive layer of the semiconductor disk, preferably differing not more than 10 % from the refractive index of said layer.

3. A method according to claim 1 or 2, characterized in that the liquid between the semiconductor disk and the projection lens is continuously exchanged and thereby influenced with respect to its temperature and/or filtered.

4. A method according to one of claims 1 to 3, characterized in that a liquid is used which wettens a resist forming the photosensitive layer and has a low viscosity.

5. A method according to claim 4, characterized in that benzene, monobromo benzene, 1-bromo-2-iodo benzene, dimethyl naphtalene or ethyl naphtalene are used.

6. A method according to claim 4, characterized in that a water-absorbing liquid is used.

7. A method according to claim 6, characterized in that 2.3-dimethyl aniline, 2-phenylethyl amine, isopropyl oxybenzene or monobromo naphtalene are used.

8. A device for implementing the method according to one of claims 1 to 7 in which a semiconductor disk is arranged below a projection lens on a support, characterized in that the support (1) is arranged in a container (2) which is open at the upper end, its upper rim lying above the lower boundary face of the projection lens (3).

9. A device according to claim 8, characterized in that the container (2) is provided with feeding and discharge pipes (4, 5) for a liquid (6).

10. A device according to claim 9, characterized in that at least one filter is provided in the liquid cycle.

11. A device according to claim 9 or 10, characterized in that means for increasing and/or reducing the temperature of the liquid are provided in the liquid cycle.

**Revendications**

1. Procédé optique lithographique pour la reproduction d'un motif sur une plaque de semi-conducteur, en particulier pour la fabrication de circuits intégrés, dans lequel un masque est reproduit à travers un objectif de projection intercalé sur une couche photosensible de la plaque de semi-conducteur, caractérisé en ce qu'au moins au cours de l'opération d'exposition l'intervalle entre la plaque de semi-conducteur et la surface de séparation de l'objectif de projection qui lui fait face est maintenu rempli d'un liquide transparent à la lumière.

2. Procédé selon la revendication 1, caractérisé en ce que l'indice de réfraction du liquide est choisi analogue à celui de la couche photosensible de la plaque de semi-conducteur, ne s'écartant pas de plus de 10 % de celui de cette couche.

3. Procédé selon l'une des revendications 1 ou 2, caractérisé en ce que le liquide entre la plaque de semi-conducteur et l'objectif de projection est constamment échangé et en même temps thermostaté et/ou filtré.

4. Procédé selon l'une des revendications 1 à 3, caractérisé en ce qu'on utilise un liquide qui mouille un vernis constituant la couche photosensible et qui présente une faible viscosité.

5. Procédé selon la revendication 4, caractérisé en ce qu'on utilise du benzène, du monobromobenzène, du 1-brome-2- iodobenzène, de la diméthylnaphtaline ou de l'éthylnaphtaline.

6. Procédé selon la revendication 4, caractérisé en ce qu'on utilise un liquide qui absorbe l'eau.

7. Procédé selon la revendication 6, caractérisé en ce qu'on utilise de la 2,3-diméthylaniline, de la 2,3-diméthylaniline, de la 2-phényléthylamine, de l'isopropyloxybenzène ou de la monobromonaphtaline.

8. Dispositif pour la mise en œuvre du procédé selon l'une des revendications 1 à 7, dans lequel une plaque de semi-conducteur est placée sur un support au-dessous d'un objectif de projection, caractérisé en ce que le support (1) est placé dans un récipient (2) ouvert vers le haut dont le bord supérieur se situe au-dessus de la surface de séparation inférieure de l'objectif de projection (3).

9. Dispositif selon la revendication 8, caractérisé en ce que le récipient (2) est équipé de conduites d'arrivée et de départ (4, 5) pour un liquide.

10. Dispositif selon la revendication 9, caractérisé en ce que le circuit de liquide comporte au moins un filtre.

11. Dispositif selon l'une des revendications 9 ou 10, caractérisé en ce que dans le circuit de liquide est prévu un dispositif respectivement pour le réchauffage et le refroidissement du liquide.

Fig.1a     Fig.1b

Fig.2

Fig.3

Fig.4